# EUROPEAN PATENT SPECIFICATION

(11) **EP 0 856 070 B1**
(45) Date of publication and mention of the grant of the patent: **15.02.2006**
(21) Application number: 97934054.4
(22) Date of filing: 09.07.1997
(51) Int. Cl.: C23C 16/44, C23C 16/50

(54) **Process for cleaning a vacuum processing chamber including the gas injection port**
Verfahren zum Reinigen eines Vakuumbearbeitungskammer einschliesslich der Gaseinlassöffnung
Procédé de nettoyage d'une chambre de traitement sous vide y inclu l'orifice d'injection de gaz

(30) Priority: 09.07.1996 US 679356
(43) Date of publication of application: 05.08.1998
(73) Proprietor: LAM RESEARCH CORPORATION, Fremont, CA 94538-6470 (US)
(72) Inventor: TRUSSELL, David, Fremont, CA 94555 (US); KOEMTZOPOULOS, C. Robert, Hayward, CA 94542 (US); KOZAKEVICH, Felix, Sunnyvale, CA 94087 (US)
(74) Representative: W.P. Thompson & Co.
(86) International application number: PCT/US1997/011686
(87) International publication number: WO 1998/001601

(56) References cited:
- EP-A- 0 354 853
- EP-A- 0 555 546
- US-A- 5 211 825
- US-A- 5 449 411

## Description

### FIELD OF THE INVENTION

The present invention relates to the field of chemical vapor deposition systems, and more particularly, to methods for cleaning the residue left by the process gas which has been injected into a plasma chamber of the system.

### BACKGROUND OF THE INVENTION

Chemical vapor deposition (CVD) systems normally employ a chamber in which gaseous chemicals react. From these reactions, a substance is deposited on a wafer surface to form dielectric, conductor, and semiconductor film layers that constitute an integrated circuit, for example. In a chemical vapor deposition system, a process gas is injected into the plasma chamber in which a plasma is formed. Due to the ion bombardment within the plasma of the process gas, (SiH₄ (silane), for example) silicon will be deposited on a wafer which has been previously placed in the chamber. During this deposition step, the gas injection ports, also known as jet screws, typically clog with silicon-rich oxide residue formed by the combined SiH₄ (the process gas) and oxygen radicals flowing into the gas injection port. These oxygen radicals originate from the plasma chamber.

The residue coats the walls of the chamber, and also tends to clog the gas injection ports. The chamber, as well as the gas injection ports, needs to be cleaned after each deposition. This ensures that each wafer encounters the same environment so that the deposition process is repeatable. Since opening up the chamber (changing out the hardware) for cleaning is very labor intensive and costly, a method for removing the deposition from the chamber walls without opening the chamber itself has been previously developed. This "insitu" cleaning has been accomplished in the past using fluorine. The fluorine is injected into the chamber as NF₃. Fluorine is known to etch silicon and silicon dioxide at high rates when it is accompanied by ion bombardment. Radio frequency (RF) power provides the energy for ion bombardment, with the NF₃ serving as the source of fluorine.

Typically, after a wafer is processed through deposition in the CVD system, the wafer is removed to a load lock. A cover wafer is then transferred to the chamber and placed on the chuck. The cover wafer is a standard silicon wafer that is coated with aluminum. It protects the chuck surface from the plasma cleaning and conditioning steps that follow.

The RF power is applied to the chamber and NF3 is injected into the chamber. The walls will then be cleaned of oxide deposition. However, there may still be a significant amount of fluorine in the chamber and on the walls and free particles. For this reason, a pre-deposition conditioning step is often required. The conditioning step is essentially a deposition that getters the fluorine and tacks down particles onto the chamber walls. When this pre-deposition conditioning step is completed, the cover wafer is transported back to its cassette and the next wafer can then be processed.

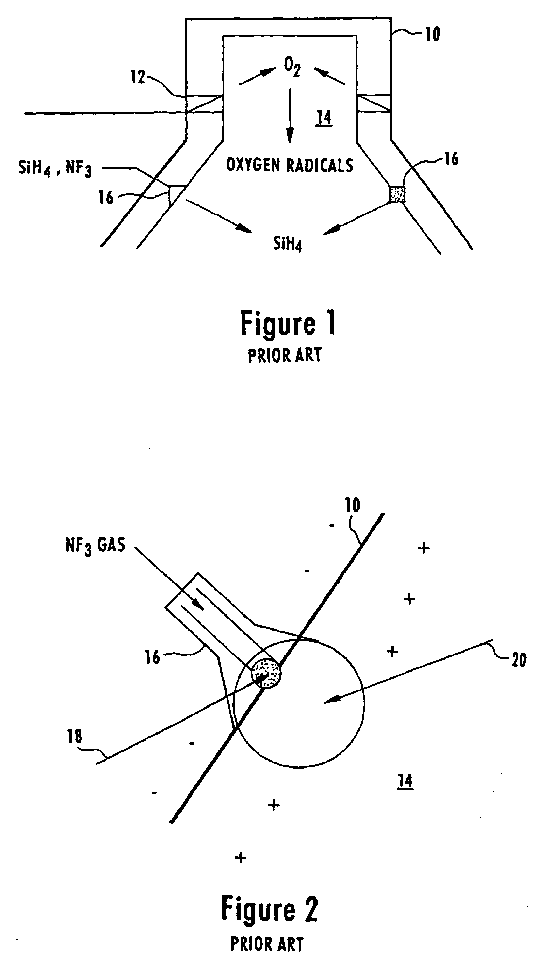

In conventional systems for routing the gas to the chamber, injection ports are shared between the deposition process gas (SiH₄) and the insitu cleaning gas (NF3). Such an arrangement is shown in prior art Figure 1 in which a portion of a process chamber is schematically depicted. The plasma chamber 10 injects oxygen at port 12 into the interior 14 of the plasma chamber. The oxygen radicals are formed within the plasma chamber 14. The shared injection ports for the deposition process gas and the insitu clean gas are depicted as reference numeral 16. During the deposition step, the gas injection ports (also known as "jet screws") clog with silicon-rich oxide residue formed by the combined SiH₄ and the incoming oxygen radicals originating from the plasma chamber.

As stated earlier, the insitu cleaning gas is designed to chemically etch the SiO₂ (silicon dioxide) residue. However, high pressure caused by supersonic gas flows in front of the jet screws form regions of scarce fluorine radicals that reduce fluorine induced etching of the SiO₂. A schematic depiction of a detail of a jet screw is provided in prior art Figure 2. NF3 gas is injected into the chamber 14 through the jet screw 16. Within the jet screw, there is SiO₂ clogging, schematically depicted at point 18 at the jet screw 16. The high pressure region 20 of scarce fluorine radicals caused by the supersonic gas flows in front of the jet screws 16 reduce the fluorine induced etching of the SiO₂ in this area, and in particular, prevent the jet screws 16 from being unclogged of the SiO₂ residue. All of the other chamber surfaces are typically cleaned except for the jet screw ports.

Due to the SiO₂ clogging of the jet screw ports, the jet screws are normally replaced after approximately 300 wafers have been processed. This process involves the shutting down of the chamber at high expense and loss of productivity. Another problem of the prior art arrangement is that the SiH₄ and NF₃ gases, if combined, are highly combustible so that routing the gases through the same injection ports can be relatively dangerous.

### SUMMARY OF THE INVENTION

There is a need for a gas routing system and method for routing gas in a plasma chamber so as to unclog the jet screws through which deposition gas is injected into the chamber.

These and other needs are met by the method according to claim 1 of the present invention which uses an arrangement for insitu cleaning of a chamber in which process gas is injected into the chamber through gas injection ports. The arrangement comprises a chamber in which a process is performed, and at least a first gas injection port in the chamber through which the process gas is injectable into the chamber. At least a second gas injection port is provided in the chamber through which insitu cleaning gas is injectable into the chamber. The cleaning gas injected into the chamber also contacts the first gas injection port to clean the first gas injection port. The first and second gas injection ports are separate ports.

By re-routing of the cleaning gas through a separate, second gas injection port, the pressures within the jet screws are equalized with the pressure of the chamber. This allows higher fluorine dissociation and SiO₂ etching.

Another advantage of the present invention is the injection of the SiH₄ and NF3 gases through completely separate manifolds, thus providing a clear safety advantage.

A further advantage of the present invention is the reduction in the amount of maintenance required of the chamber. For example, using the gas routing system of the present invention, the chamber does not need to be maintained for approximately 3,000 wafers. This is a decided advantage over the prior art in which the jet screws needed to be replaced after only 300 wafers.

Another advantage of the present invention is that the insitu clean time is decreased due to more efficient cleaning of the jet screws. This provides a throughput advantage of, for example, two wafers per hour. Finally, another advantage is that plasma to surface arcing is completely eliminated in the jet screw area.

Another embodiment of the present invention satisfies the earlier stated needs by providing a method of routing gas to a plasma chamber comprising the steps of: injecting process gas into the plasma chamber through a first gas injection port, and injecting cleaning gas into the plasma chamber through a second gas injection port. The second gas injection port is separate from the first gas injection port. The cleaning gas cleans the plasma chamber and the first gas injection port.

Another method of the present invention provides for unclogging jet screw ports in the chamber. The jet screw ports inject process gas into the chamber. This method comprises the steps of terminating injection of the process gas into the chamber and injecting cleaning gas into the chamber through openings separate from the jet screw ports to equalize pressure of the cleaning gas within the jet screw ports with pressure of the cleaning gas within the chamber.

In a preferred embodiment of the present invention, an electron cyclotron resonance chemical vapor deposition system is used. This system includes an electron cyclotron resonance plasma chamber, and a gas supply that supplies plasma forming gas, process gas, and cleaning gas to the plasma chamber. The plasma chamber has a first port through which the process gas is supplied, and a second port, separate from the first port, through which the cleaning gas is supplied.

The foregoing and other features, aspects and advantages of the present invention will become more apparent from the following detailed description of the present invention when taken in conjunction with the accompanying drawings.

### BRIEF DESCRIPTION OF THE DRAWINGS

Figure 1 is a schematic depiction of a portion of a process chamber in accordance with the prior art.
Figure 2 is a schematic depiction of a detail of a portion of the process chamber.
Figure 3 is a schematic cross-sectional diagram of an electron cyclotron resonance chemical vapor deposition system constructed in accordance with an embodiment of the present invention.
Figure 4 is a schematic cross-sectional diagram of a chemical vapor deposition system constructed in accordance with another embodiment of the present invention.

### DETAILED DESCRIPTION OF THE DRAWINGS

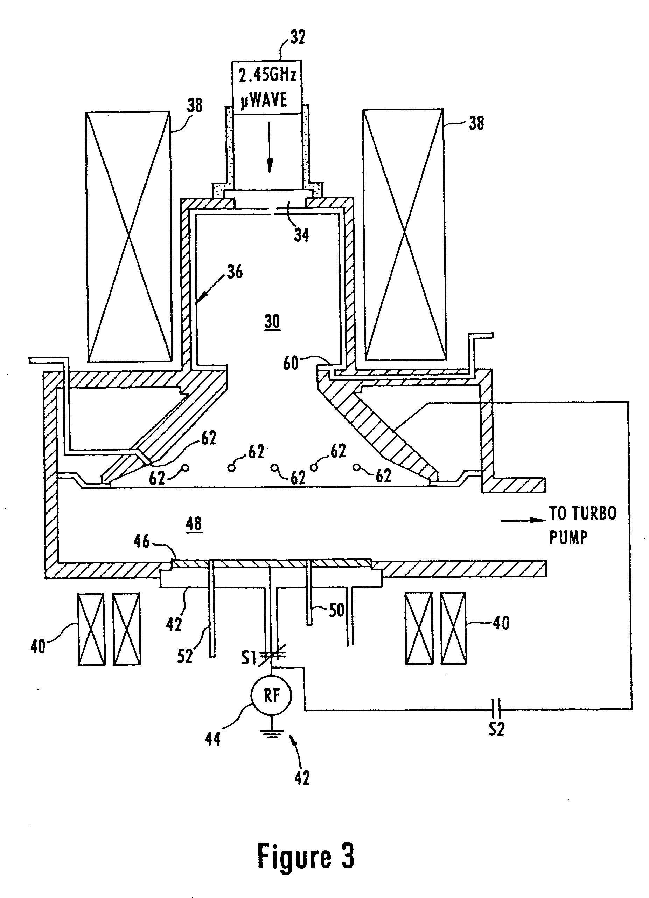

A schematic depiction of a cross-section of a electron cyclotron resonance chemical vapor deposition system constructed in accordance with an embodiment of the present invention is provided in Figure 3. The system includes an electron cyclotron resonance plasma chamber 30 having a 2.45GHz microwave power supply 32. The microwaves pass through a microwave window 34 into the plasma chamber 30. A quartz liner 36 lines the interior of the plasma chamber 30.

Plasmas are generated by the ionization of gas molecules. This may be accomplished by an energetic electron striking a neutral molecule. Electrons can also cause dissociation and other excitations. The electrons are excited by electric fields such as RF and microwaves. As such, these are the conventional methods for generating processing plasmas.

In contrast to conventional plasmas that typically operate at pressures greater than 9.1 Pascal, high density plasmas generally operate at pressures in the range of 0.067 to 1.3 Pascal. The ion to neutral ratio can be as high as one in a hundred (compared to less than one in a million in low density plasmas). Ion densities can be more than 1E12 per cubic centimeter. Such plasmas require sophisticated plasma generation techniques such as electron cyclotron resonance.

In an electron cyclotron resonance plasma chamber, the electron angular frequency due to the magnetic field matches a microwave frequency, so that electron cyclotron resonance occurs. In this state, electrons gain energy from the microwave source and accelerate in a circular motion. The cross-section for ionization is therefore effectively increased, allowing for the creation of high density plasma at low pressure.

The magnetic field is also used to extract the ions out of the plasma source. The ions follow the lines of induction toward the wafer. The plasma tends to be cone-shaped due to the divergent magnetic field. The divergent magnetic field creates a force that pulls the electrons out of the plasma chamber. The resulting potential extracts ions to form a varied directional plasma stream.

The divergent magnetic field is created by a primary coil 38 that supplies the 875 Gauss that is needed for the electron cyclotron resonance condition. This primary coil 38 also provides the divergent magnetic field for ion extraction.

Auxiliary magnetic coils 40 are provided behind a wafer holder assembly 42 to shape the plasma into the desired shape. The wafer holder assembly 42 holds a wafer (not illustrated in Figure 3). The wafer holder 42 includes a 13.56 MHz RF power supply (up to 2500W). The RF power supply provides, along with the microwaves, the electric fields that excite the electrons to generate the processing plasma.

An electrostatic chuck is provided to hold the wafers within a reactor chamber 48. The use of an electrostatic chuck obviates the need for mechanical clamping of the wafer. Wafer cooling is provided by helium, for example, to the underneath or backside of the wafer through a helium supply line 50. Closed-loop control of the helium pressure regulates the wafer temperature during deposition. Insitu wafer temperature monitoring is provided through a temperature probe 52 which sends its sensor signals to a controller (not depicted). A 3,000 1/sec turbomolecular pump with a base pressure less than 13x1.0⁻³ Pascal! used to control the pressure within the plasma chamber 30 and the reactor chamber 48.

A wafer transport mechanism (not depicted) is provided for transporting wafers into and out of the reactor chamber 48. A conventional wafer transport system may be used for this purpose.

In certain embodiments of the present invention, oxygen and argon are provided into the plasma chamber 30 from a gas supply through an injection port 60. Plasma will be generated in the plasma chamber upon application of the RF energy and microwave energy by the RF generator 44 and the microwave generator 32.

Once a wafer has been transported into the reactor chamber 48 by the wafer transport system and placed onto the electrostatic chuck 46, and a plasma has been generated within the plasma chamber 30, the deposition gas (SiH₄, for example,) is introduced into the plasma chamber 30 through one or more gas injection ports 62 that are separate from the gas injection port through which the gas to form the plasma is provided. The gas injection ports 62 are jet screws, for example. During deposition, these jet screws, along with the remaining surfaces of the plasma chamber 30 and the reactor chamber 48, become coated with a residue (SiO₂). This residue should be cleaned from the surfaces of the chamber and the interior of the jet screws 62 between the processing of each wafer, so that each wafer will encounter the same environment, thereby making the process repeatable. Accordingly, the cleaning gas (NF₃, in the exemplary embodiment of the present invention) is introduced into the plasma chamber and RF power is applied from the RF generator 44 to the plasma chamber 30.

As discussed earlier, in the prior art arrangement, the jet screw port 62 becomes clogged with the SiO₂ residue, and injection of the NF3 cleaning gas through the jet ports 62 produced a high pressure region in the plasma chamber 30 directly in front of the jet screw during the insitu cleaning step. This caused a poor flourine dissociation due to the high localized pressure in front of the jet screw ports 62. As a consequence, there was not a sufficient amount of flourine radicals to react with the SiO₂ to clean the jet screw ports 62 sufficiently. Since the jet screw ports 62 were not being cleaned sufficiently during insitu cleaning, their frequent replacement, for example after approximately 300 wafers, was required.

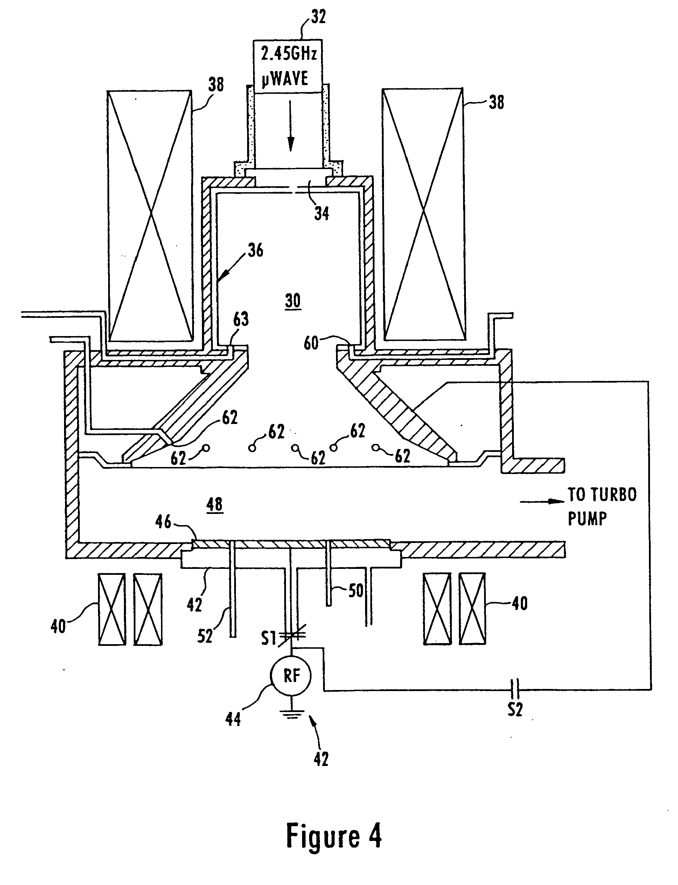

In the present invention, as depicted in Figure 3, the NF3 cleaning gas is injected into the plasma chamber 30 through injection port 60, the same port through which the oxygen and argon gas is injected. This injection port 60 is separate from the injection ports (jet screw ports) 62 through which the deposition gas is injected. In other embodiments of the invention, the cleaning gas is injected in a dedicated port, exclusively devoted to cleaning gas injection. Such an embodiment is depicted in Figure 4, in which the cleaning gas is injected through its own dedicated port 63, the oxygen and argon gas being injected through injection port 60, and the SiO₂ being injected through the jet screw ports 62.

The routing of the cleaning gas to be injected into the plasma chamber 30 through a port separate from the injection port through which the deposition gas is injected has a number of advantages, including the equalization of pressure within the jet screw 62 and the plasma chamber 30 during insitu cleaning. This prevents the high pressure region in the plasma chamber 30 and jet screw 62 from forming. As a consequence, there is no longer a poor flourine disassociation due to the high localized pressure in front of the jet screws 62. The jet screws 62 will therefore be cleaned to relatively the same extent as the other surfaces of the plasma chamber 30.

Another advantage provided by the separate routing of the cleaning gas and the deposition gas is related to safety. As stated earlier, the SiH₄ and NF₃ gases are highly combustible if combined. Their separation according to the present invention provides a clear safety advantage. Also, all plasma to surface arcing is eliminated in the area of the jet screw ports 62. Further, the superior cleaning performance within the jet screw 62 eliminates the need for replacing the jet screws after only 300 wafers. The inventors have found that no maintenance is required in the plasma chamber 30 for approximately 3,000 wafers. This is an extremely significant advantage in reducing the amount of downtime for maintenance of the chamber. Related to this, the insitu clean time is also decreased due to a more efficient cleaning of the jet screw ports 62. For example, a throughput advantage of approximately at least 2 wafers per hour may be realized using the gas routing system of the present invention. Where the processing of a single wafer provides high profits, the throughput of the wafers is critical.

An exemplary embodiment of the operation of the invention is as follows. After the deposition process has been completed, and the deposition gas is no longer being supplied to the plasma chamber 30, the wafer being processed is removed by the wafer transport system to the load lock. At this point, a cover wafer is transferred to the reactor chamber 48 and placed on the electrostatic chuck 46. The cover wafer is a standard silicon wafer that is coated with aluminum. The purpose of the cover wafer is to protect the chuck surface from the plasma cleaning and conditioning step.

Once the cover wafer is in place, the RF power is applied to the plasma chamber 30 and the NF₃ cleaning gas is injected in the plasma chamber 30 through port 60. After the walls of the chamber 30 and the jet screw port 62 have been cleaned of oxide deposition, there is still a fair amount of fluorine in the chamber 30 and on the walls, as well as free particles. For this reason, a pre-deposition conditioning step may be used. The conditioning step is essentially a deposition that getters the fluorine and tacks down particles. When this pre-deposition conditioning step is completed, the cover wafer is then transported back to its cassette and the next wafer can then be processed.

Although the present invention has been described with an electron cyclotron resonance chemical vapor deposition system, the invention also finds use in other types of systems employing a plasma chamber in which a deposition gas is injected, leaving a residue that must be cleaned by an insitu cleaning gas. Also, although an exemplary embodiment has been described with specific gases for the deposition gas, the oxygen and argon forming gases, and the cleaning gas, the invention is not limited to such gases, and may be used with other types of gases without departing from the spirit or scope of the present invention.

Although the present invention has been described and illustrated in detail, it is to be clearly understood that the same is by way of illustration and example only and is not to be taken by way of limitation, the scope of the present invention being limited only by the terms of the appended claims.

## Claims

1. A method of in situ cleaning a vacuum processing chamber between workpiece processing operations wherein the workpiece processing is performed by supplying processing gas to the chamber via a first port, the processing gas having a tendency to leave a clogging residue in the first port due to it being treated in a plasma, the chamber including a second port separate from the first port, the method including introducing a cleaning gas into the chamber via the second port without opening the chamber white (a) the processing gas is not supplied to of the chamber and (b) r.f. plasma excitation power is applied to a structure of the chamber including the first port which is arranged to be located in the plasma, and so that pressure is equalized at the first port and the cleaning gas cleans the first port of the clogging residue as well as the remainder of the chamber.

2. A method as claimed in claim 1 wherein the cleaning gas is NF₃.

3. A method as claimed in claim 1 or claim 2 including applying electric energy to the cleaning gas to establish a plasma that cleans the first port and the chamber of the residue.

4. A method as claimed in claim 3 wherein the workpiece processing is performed by energizing the processing gas to a plasma by an electron cyclotron resonance structure including a structure in the chamber for supplying plasma excitation microwave energy to the processing gas, the electric energy being applied to the cleaning gas to establish the plasma that cleans the first port by supplying the r.f. plasma excitation power to the same structure in the chamber that supplies plasma excitation microwave energy to the processing gas.

5. A method as claimed in any one of claims 1 to 4 including applying a getter to the chamber after the cleaning gas has been applied and before workpiece processing begins, the getter removing residual atoms of the cleaning gas from the chamber.

6. A method as claimed in any one of claims 1 to 5 wherein the chamber includes a workpiece holder, including the step of covering the workpiece holder while the cleaning gas is applied to the chamber via the second cleaning port.

7. A method as claimed in claim 6, when dependent upon claim 5, wherein the workpiece holder is covered while the getter is applied to the chamber.

8. A method as claimed in claim 6 or claim 7, including performing a deposition after the cleaning agent etches the deposits to getter the cleaning agent and while the workpiece holder is covered, then uncovering the workpiece holder, and then performing workpiece processing operations.

9. A method as claimed in any one of claims 1 to 8 including introducing a second processing gas into the chamber through the second port during vacuum plasma processing of the workpieces, the second processing gas being of a type that (a) does not have a tendency to form a residue in the second port and (b) reacts chemically with the first reaction gas.

10. A method as claimed in claim 9 wherein the second processing gas includes argon and oxygen.

11. A method as claimed in claim 9 or claim 10 wherein the processing gas of claim 1 includes SiH₄ and the residue includes SiO₂.

12. A method as claimed in any one of claims 1 to 8 wherein gas is not introduced into the chamber through the second port during workpiece processing, including introducing another reaction gas into the chamber via a third port during workpiece processing, the reaction gases introduced into the chamber via the first and third ports chemically reacting during workpiece processing.

13. A method as claimed in any one of claims 1 to 12 wherein the first port while clogged and while gas is applied to it establishes a high pressure region which resists the flow of gas through the first port into the chamber, and the cleaning gas is applied to the second port in such a manner that pressure is equalized at the first port and the cleaning gas unclogs the first port of the residue.

## Revendications

1. Procédé de nettoyage in situ d'une chambre de traitement sous vide entre des opérations de traitement de pièces ouvrées dans lequel le traitement des pièces ouvrées est réalisé en fournissant du gaz de traitement dans la chambre par le biais d'un premier orifice, le gaz de traitement ayant tendance à laisser un résidu colmatant dans le premier orifice en raison de son traitement en un plasma, la chambre comprenant un deuxième orifice séparé du premier orifice, le procédé comprenant l'introduction d'un gaz de nettoyage dans la chambre par le biais du deuxième orifice sans ouvrir la chambre alors que (a) le gaz de traitement n'est pas fourni dans la chambre et (b) une puissance d'excitation à plasma radiofréquence est appliquée au niveau d'une structure de la chambre comprenant le premier orifice qui est disposé pour être situé dans le plasma, et de telle manière que la pression est égalisée au niveau du premier orifice et le gaz de nettoyage nettoie le premier orifice pour y éliminer le résidu colmatant et de même pour ce qui est du reste de la chambre.

2. Procédé selon la revendication 1, dans lequel le gaz de nettoyage est du NF₃.

3. Procédé selon la revendication 1 ou la revendication 2 comprenant l'application d'une énergie électrique au gaz de nettoyage pour mettre en oeuvre un plasma qui nettoie le premier orifice et la chambre pour y éliminer le résidu.

4. Procédé selon la revendication 3, dans lequel le traitement des pièces ouvrées est réalisé en excitant le gaz de traitement jusqu'à transformation en plasma par le biais d'une structure à résonance cyclotronique électronique comprenant une structure dans la chambre pour fournir une énergie à micro-ondes d'excitation à plasma au gaz de traitement, l'énergie électrique étant appliquée au gaz de nettoyage pour mettre en oeuvre le plasma qui nettoie le premier orifice en fournissant de la puissance d'excitation à plasma radiofréquence à la même structure dans la chambre qui fournit de l'énergie à micro-ondes d'excitation à plasma au gaz de traitement.

5. Procédé selon l'une quelconque des revendications 1 à 4, comprenant l'application d'un getter au niveau de la chambre après l'application du gaz de nettoyage et avant le commencement du traitement des pièces ouvrées, le getter retirant les atomes résiduels du gaz de nettoyage de la chambre.

6. Procédé selon l'une quelconque des revendications 1 à 5, dans lequel la chambre comprend un support pour pièces ouvrées, comprenant l'étape de masquage du support pour pièces ouvrées lorsque le gaz de nettoyage est appliqué dans la chambre par le biais du deuxième orifice de nettoyage.

7. Procédé selon la revendication 6, quand dépendante de la revendication 5, dans lequel le support pour pièces ouvrées est masqué lorsque le getter est appliqué au niveau de la chambre.

8. Procédé selon la revendication 6 ou la revendication 7, comprenant la réalisation d'un dépôt après que l'agent de nettoyage grave les dépôts pour absorber l'agent de nettoyage par effet getter et alors que le support pour pièces ouvrées est masqué, puis le démasquage du support pour pièces ouvrées, et puis la réalisation des opérations de traitement des pièces ouvrées.

9. Procédé selon l'une quelconque des revendications 1 à 8, comprenant l'introduction d'un deuxième gaz de traitement dans la chambre au travers du deuxième orifice au cours du traitement des pièces ouvrées au plasma sous vide, le deuxième gaz de traitement étant un gaz du type qui (a) n'a pas tendance à former de résidu dans le deuxième orifice et (b) réagit chimiquement avec le premier gaz de réaction.

10. Procédé selon la revendication 9, dans lequel le deuxième gaz de traitement comprend l'argon et l'oxygène.

11. Procédé selon la revendication 9 ou la revendication 10, dans lequel le gaz de traitement de la revendication 1 comprend le SiH₄ et dans lequel le résidu comprend la SiO₂.

12. Procédé selon l'une quelconque des revendications 1 à 8, dans lequel du gaz n'est pas introduit dans la chambre par le biais du deuxième orifice au cours du traitement des pièces ouvrées, y compris l'introduction d'un autre gaz de réaction dans la chambre par le biais d'un troisième orifice au cours du traitement des pièces ouvrées, les gaz de réaction introduits dans la chambre par le biais du premier et du troisième orifices réagissant chimiquement au cours du traitement des pièces ouvrées.

13. Procédé selon l'une quelconque des revendications 1 à 12, dans lequel le premier orifice alors que celui-ci est colmaté et alors que du gaz y est appliqué met en oeuvre une zone de haute pression qui résiste au débit du gaz au travers du premier orifice dans la chambre, et dans lequel le gaz de nettoyage est appliqué au niveau du deuxième orifice d'une telle manière que la pression est égalisée au niveau du premier orifice et le gaz de nettoyage désobstrue le premier orifice pour éliminer le résidu.

## Patentansprüche

1. Verfahren zur Reinigung vor Ort einer Vakuumverarbeitungskammer zwischen Werkstückverarbeitungsvorgängen, wobei die Werkstückverarbeitung ausgeführt wird, indem der Kammer über eine erste Öffnung Prozessgas zugeführt wird, wobei das Prozessgas aufgrund der Tatsache, dass es in einem Plasma behandelt wird, dazu neigt, einen verstopfenden Rückstand in der ersten Öffnung zurückzulassen, die Kammer eine zweite Öffnung umfasst, die von der ersten Öffnung getrennt ist, das Verfahren das Einführen eines Reinigungsgases durch die zweite Öffnung in die Kammer umfasst, ohne dass die Kammer geöffnet wird, während (a) das Prozessgas nicht der Kammer zugeführt wird und (b) HF-Plasmaerregungsstrom an eine Struktur der Kammer angelegt wird, die die erste Öffnung umfasst, die so ausgelegt ist, dass sie sich in dem Plasma befindet, so dass Druck an der ersten Öffnung ausgeglichen wird und das Reinigungsgas die erste Öffnung von dem verstopfenden Rückstand sowie den Rest der Kammer reinigt.

2. Verfahren nach Anspruch 1, wobei das Reinigungsgas NF₃ ist.

3. Verfahren nach Anspruch 1 oder Anspruch 2, das das Anlegen von elektrischer Energie an das Reinigungsgas umfasst, um ein Plasma zu erzeugen, das die erste Öffnung und die Kammer von dem Rückstand reinigt.

4. Verfahren nach Anspruch 3, wobei die Werstückverarbeitung ausgeführt wird, indem das Prozessgas durch eine Elektronzyklotronresonanzstruktur zu einem Plasma erregt wird, wobei die Elektronzyklotronresonanzstruktur eine Struktur in der Kammer umfasst, um dem Prozessgas Plasmaerregungsmikrowellenenergie zuzuführen und die elektrische Energie an das Reinigungsgas angelegt wird, um das Plasma zu erzeugen, das die erste Öffnung reinigt, indem der HF-Plasmaerregungsstrom an dieselbe Struktur in der Kammer angelegt wird, die dem Prozessgas die Plasmaerregungsmikrowellenergie zuführt.

5. Verfahren nach einem der Ansprüche 1 bis 4, das das Anwenden eines Getters auf die Kammer umfasst, nachdem das Reinigungsgas angewendet worden ist und bevor die Werkstückverarbeitung beginnt, wobei der Getter rückständige Atome des Reinigungsgases aus der Kammer entfernt.

6. Verfahren nach einem der Ansprüche 1 bis 5, wobei die Kammer einen Werkstückhalter umfasst und das Verfahren den Schritt des Bedeckens des Werkstückhalters umfasst, während das Reinigungsgas durch die zweite Reinigungsöffnung auf die Kammer angewendet wird.

7. Verfahren nach Anspruch 6, wenn von Anspruch 5 abhängig, wobei der Werkstückhalter bedeckt ist, während der Getter auf die Kammer angewendet wird.

8. Verfahren nach Anspruch 6 oder Anspruch 7, das Folgendes umfasst:
Ausführen einer Auftragung, nachdem das Reinigungsmittel die Ablagerungen geätzt hat, um das Reinigungsmittel zu gettern, und während der Werkstückhalter bedeckt ist, daraufhin das Aufdecken des Werkstückhalters und daraufhin das Ausführen von Werstückverarbeitungsvorgängen.

9. Verfahren nach einem der Ansprüche 1 bis 8, das das Einführen eines zweiten Prozessgases während der Vakuumplasmaverarbeitung der Werkstücke durch die zweite Öffnung in die Kammer umfasst, wobei das zweite Prozessgas von einer Art ist, die (a) nicht dazu neigt, einen Rückstand in der zweiten Öffnung zu bilden, und (b) chemisch mit dem ersten Reaktionsgas reagiert.

10. Verfahren nach Anspruch 9, wobei das zweite Prozessgas Argon und Sauerstoff umfasst.

11. Verfahren nach Anspruch 9 oder Anspruch 10, wobei das Prozessgas nach Anspruch 1 SiH₄ umfasst und der Rückstand SiO₂ umfasst.

12. Verfahren nach einem der Ansprüche 1 bis 8, wobei während der Werkstückverarbeitung kein Gas durch die zweite Öffnung in die Kammer eingeführt wird, wobei das Verfahren das Einführen eines anderen Reaktionsgases während der Werkstückverarbeitung über eine dritte Öffnung in die Kammer umfasst, wobei die über die erste und dritte Öffnung in die Kammer eingeführten Reaktionsgase während der Werkstückverarbeitung chemisch reagieren.

13. Verfahren nach einem der Ansprüche 1 bis 12, wobei die erste Öffnung, während sie verstopft ist und während Gas an diese angelegt wird, einen Hochdruckbereich erzeugt, der der Gasströmung durch die erste Öffnung in die Kammer widersteht, und das Reinigungsgas derart auf die zweite Öffnung angewendet wird, dass Druck an der ersten Öffnung ausgeglichen wird und das Reinigungsgas die erste Öffnung von dem Rückstand befreit.
